# EUROPÄISCHE PATENTSCHRIFT

(11) **EP 0 886 880 B1**
(45) Veröffentlichungstag und Bekanntmachung des Hinweises auf die Patenterteilung: **13.03.2002**
(21) Anmeldenummer: 96937963.5
(22) Anmeldetag: 22.11.1996
(51) Int. Cl.: H01J 37/32

(54) **VERFAHREN UND ANLAGE ZUR BESCHICHTUNG VON WERKSTÜCKEN**
METHOD AND APPARATUS FOR THE COATING OF WORKPIECES
PROCEDE ET DISPOSITIF POUR LE REVETEMENT DE PIECES

(30) Priorität: 11.03.1996 CH 62796
(43) Veröffentlichungstag der Anmeldung: 30.12.1998
(73) Patentinhaber: Unaxis Balzers Aktiengesellschaft, 9496 Balzers (LI)
(72) Erfinder: BRAENDLE, Hans, CH-7320 Sargans (CH); KIND, Bruno, FL-9495 Triesen (LI)
(86) Internationale Anmeldenummer: CH9600412
(87) Internationale Veröffentlichungsnummer: WO9734315

(56) Entgegenhaltungen:
- EP-A- 0 413 853
- DE-A- 4 310 286
- GB-A- 2 049 560
- US-A- 4 929 321

## Beschreibung

Die vorliegende Erfindung betrifft eine Beschichtungsanordnung nach dem Oberbegriff von Anspruch 1 sowie ein Verfahren zur Beschichtung von Werkstücken nach dem Oberbegriff von Anspruch 13.

Für verschiedene Vakuumbehandlungsprozesse ist es bekannt vorgängig zur Vakuumbeschichtung einen Reinigungsschritt an der Werkstückoberfläche vorzunehmen. Ausserdem können vor oder nach dem Reinigungsschritt die Werkstücke zusätzlich auf eine gewünschte Temperatur aufgeheizt werden. Solche Schritte sind vor allem notwendig, um der Schicht die nachfolgend abgeschieden werden soll, eine gute Haftfestigkeit zu verleihen. Besonders wichtig ist dies bei Anwendungen, wo Werkstücke, insbesondere Werkzeuge, mit einer verschleissfesten Hartstoffschicht beschichtet werden sollen. Solche Schichten sind bei Werkzeugen, wie beispielsweise bei Bohrern, Fräsern, Räumnadeln und Umformwerkzeugen besonders hohen mechanischen und abrasiven Beanspruchungen ausgesetzt. Eine extrem gute Haftung mit der Unterlage ist deshalb Voraussetzung für einen brauchbaren und wirtschaftlichen Einsatz. Eine bewährte Methode solche Werkstücke vorzubehandeln ist einerseits das Heizen mit Elektronenbeschuss und andererseits das Ätzen mittels Ionenätzen beziehungsweise Zerstäubungsätzen. Das Beheizen mittels Elektronenbeschuss aus einer Plasmaentladung ist beispielsweise bekannt geworden aus der DE 33 30 144. Eine Plasmaentladungsstrecke kann auch verwendet werden, um schwere Edelgasionen zu erzeugen, beispielsweise Argonionen, welche aus diesem Plasma auf das Werkstück beziehungsweise das Substrat beschleunigt werden, um dort ein Zerstäubungsätzen zu bewirken, wie dies in der DE 28 23 876 beschrieben ist. Neben dem Zerstäubungsätzen ist es auch bekannt geworden, Plasmaentladungen mit zusätzlichen Reaktivgasen zu betreiben und die Werkstücke reaktivchemisch zu ätzen, wobei auch Mischformen zwischen diesem Reaktivätzen und dem Zerstäubungsätzen möglich sind. Bei all diesen Vorbehandlungsverfahren geht es darum, die Werkstücksoberfläche so vorzubereiten, dass die nachfolgende Beschichtung gut auf der Unterlage haftet. Zur Plasmaerzeugung wird bei den vorerwähnten Anordnungen eine Niedervoltbogenentladung verwendet, welche in der Zentralachse der Anlage angeordnet ist, wobei die Werkstücke in einem bestimmten Abstand um diesen Bogen herum und entlang einer Zylinderfläche angeordnet sind. Die Beschichtung erfolgt anschliessend mittels thermischem Aufdampfen oder Zerstäuben. Je nach Prozessführung wird hierbei durch entsprechenden Substratbias während der Beschichtung ein zusätzlicher Ionenbeschuss erzeugt, welcher unter dem Begriff Ionenplattieren bekannt geworden ist. Diese Anordnung hat den Vorteil, dass aus der Niedervoltbogenentladung grosse Ionenströme bei niederer Teilchenenergie gezogen werden können und somit das Werkstück schonend bearbeitet werden kann. Von Nachteil ist allerdings, dass die Werkstücke in einer radial zur Entladung definierten Zone angeordnet werden müssen und in der Regel auch sowohl um die Zentralachse, wie auch um ihre eigene Achse rotiert werden müssen, um gleichförmige und reproduzierbare Ergebnisse erzielen zu können. Ein weiterer Nachteil besteht darin, wegen der relativ engen zulässigen zylinderförmigen Bearbeitungsbandbreite die bearbeitbare Werkstückgrösse einerseits begrenzt ist oder andererseits die Chargiermenge mit einer grösseren Anzahl kleiner Werkstücke limitiert ist, womit die Wirtschaftlichkeit der bekannten Anordnung stark eingeschränkt ist. Diese Einschränkung kommt dadurch zu Stande, dass die Niedervoltbogenentladung, welche die Bearbeitungskammer zentral durchdringt, für sich eine gewisse Ausdehnung beansprucht und um gute und reproduzierbare Ergebnisse zu erhalten, die Werkstücke entsprechend von der Entladung beabstandet sein müssen, womit ein grosser Teil des zentralen Raumes der Bearbeitungskammer nicht genutzt werden kann.

Bekannt geworden sind auch Zerstäubungsanordnungen mit sogenannten Diodenentladungen. Solche Diodenentladungen werden mit hohen Spannungen bis 1000 Volt und darüber betrieben. Diodenätzeinrichtungen haben sich für Anwendungen mit hohen Anforderungen nicht bewährt. Einerseits sind die erzielbaren Ätzraten und somit die Wirtschaftlichkeit gering und andererseits treten bei diesen hohen Spannungen Defekte an heiklen Substraten auf. Insbesondere Werkstücke, die dreidimensional bearbeitet werden müssen, wie beispielsweise Werkzeuge, können damit nicht ohne weiteres behandelt werden. Werkzeuge beispielsweise weisen durch ihre Ausformung, beispielsweise verschiedene feine Schneidkanten auf, auf welche sich solche Entladungen konzentrieren, wobei dann an diesen feinen Kanten und Spitzen unkontrollierbare Effekte auftreten können, wie beispielsweise ein Überhitzen und sogar ein Zerstören der funktionalen Kante.

In der Patentschrift DE 41 25 365 ist ein Ansatz beschrieben, der versucht das vorerwähnte Problem zu lösen. Diese Offenbarung geht davon aus, dass die Beschichtung mittels sogenannten Arc- oder Lichtbogenverdampfung erfolgt. Um mit solchen Verdampfern haftfeste Schichten erzeugen zu können, wurde der Lichtbogen des Verdampfers selbst vor der eigentlichen Beschichtung auf diese Weise genutzt, dass die im Lichtbogen erzeugten Ionen, insbesondere die Metallionen, erzeugt aus dem Verdampfungstarget, über eine negative Beschleunigungsspannung von typischerweise > 500 Volt oft aber im Bereich von 800 - 1000 Volt auf die Werkstücke beschleunigt wird, so dass am Werkstück mehr abgestäubt wird als aufgebracht wird. Nach diesem Ätzvorgang wird dann der Verdampfer weiter als Beschichtungsquelle betrieben. In der Beschreibung ist erwähnt, dass bei diesen üblichen Verfahren mit der Arcbeschichtungstechnik solch hohe Spannungen notwendig sind, um mit der Arcverdampfungstechnik haftfeste Schichten erzeugen zu können. Um das Problem der Überhitzung oder Anätzung an ungleichmässiger Massenverteilung beziehungsweise an feinen Geometrien des Werkstücken vermeiden zu können, wird in der Beschreibung nun vorgeschlagen, neben dem Lichtbogenplasma eine weitere Hilfsentladungsstrecke mit hoher Spannung zu betreiben, welche eine Zusatzionisierung bewirkt und an den Arcverdampferlichtbogen gekoppelt ist, wobei eine zusätzliche Gleichstromquelle bewirkt, dass aus dem Plasma Ionen extrahiert und auf das Werkstück beschleunigt werden, welche den gewünschten Ätzvorgang erzeugen. Zusätzlich ist eine weitere Anode mit einer weiteren Entladungsstrecke, welche von einer zusätzlichen Stromversorgung betrieben wird vorgesehen, um die Wirkung zu erhöhen. Ausserdem wird der Arcverdampfer beim Ätzvorgang mit geschlossener Blende betrieben, so dass während diesem Vorgang das Substrat von der direkten Wirkung des Verdampfers abgeschirmt wird, um sogenannte Droplets am Substrat zu verhindern. Die beschriebene Anordnung weist den Nachteil auf, dass ebenfalls hohe Spannungen notwendig sind und die erzielbaren Bearbeitungshomogenitäten nur in beschränkten Bereichen möglich ist, wobei durch die Verkopplung der verschiedenen Plasmastrecken ausserdem die Einstellmöglichkeiten der Betriebsbedingungen beschränkt sind. Ausserdem ist die Anordnung kompliziert und somit aufwendig in der Realisierung und im Betrieb, was für die Wirtschaftlichkeit einer Produktionsanlage von Nachteil ist. Die Verwendung von höheren Spannungen über 1000 Volt verlangt ausserdem zusätzliche Sicherheitsaufwendungen.

Anlagen wie sie gemäss Stand der Technik bekannt sind eignen sich nur bedingt für grosse Durchsätze bei hoher Bearbeitungsqualität. Anlagengrössen welche Beschichtungsbreiten von bis zu 1000 mm und mehr zulassen sind, wenn überhaupt nur, unter grössten Schwierigkeiten realisierbar.

Es ist Aufgabe der vorliegenden Erfindung die erwähnten Nachteile des Standes der Technik zu beheben, insbesondere eine Beschichtungsanordnung zu schaffen und ein Verfahren vorzuschlagen, welche es erlauben, haftfeste Beschichtungen auf eine Vielzahl von Werkstücken oder auf einzelne grosse Werkstücke mit ungleichmässiger Massenverteilung ohne Defekte an den Feinstrukturen aufzubringen bei der gewünschten Homogenität und mit der erforderlichen hohen wirtschaftlichen Bearbeitungsrate.

Dies wird ausgehend von einer Bearbeitungsanordnung eingangs genannter Art, durch deren Ausbildung nach dem kennzeichnenden Teil von Anspruch 1 erreicht und durch das Beschichtungsverfahren ausgebildet nach dem kennzeichnenden Teil von Anspruch 13.

Demnach wird die zu beschichtende Werkstückoberfläche an einer Plasmaquelle, welche als Heisskathoden-Niedervoltbogen-Entladungsanordnung ausgebildet ist, quer zu ihrer linearen Ausdehnung an dieser Entladungsstrecke vorbeigeführt, wobei das Werkstück auf negativer Spannung liegt, womit Ionen aus der Bogenentladung extrahiert werden und auf das Werkstück beschleunigt werden, um dieses zerstäubungszuätzen und anschliessend das Werkstück von der gleichen Seite her wirkend, wie die Niedervoltbogenentladung, beschichtet wird.

Bevorzugte Ausführungsformen der erfindungsgemässen Beschichtungsanordnung sind in den abhängigen Ansprüchen 2 bis 12 aufgeführt und die bevorzugten Ausführungsformen des Verfahrens in den Ansprüchen 13 bis 16.

Das Ätzen mit einer Heisskathoden-Niedervoltbogen-Entladungsanordnung als Ionenquelle ist besonders vorteilhaft, da solche Bogenentladungen mit Entladungsspannungen von < 200 Volt betrieben werden können und die Nachteile des Hochspannungsätzen nicht auftreten. Das Ätzen mit Niedervoltbogenentladungen ist also besonders schonend für das Werkstück, das heisst feine Strukturen an grösseren Werkstücken wie beispielsweise Schneidkanten, werden weder durch thermische Überlastung noch durch Kantenverrundung durch höher energetischen Ionenbeschuss negativ beeinträchtigt. Trotz der relativ niederen möglichen Entladungsspannung im Bereich von 30 bis 200 Volt DC, vorzugsweise im Bereich von 30 bis 120 Volt, ein sehr hoher Entladungsstrom möglich von einigen 10 bis einige 100 Ampere, vorzugsweise von 100 bis 300 Ampere möglich. Dies bedeutet, dass diese Entladungsart in der Lage ist, einen sehr hohen Ionenstrom bei geringer Energie zur Verfügung zu stellen. Es kann somit bei relativ geringer Beschleunigungsspannung am Substrat durch den hohen verfügbaren Ionenstrom eine hohe Ätzrate erreicht werden und dies wie erwähnt bei schonender Behandlung des Werkstückes. Die Extraktionsspannung beziehungsweise die Beschleunigungsspannung am Substrat liegt in einem Bereich von -50 Volt bis -300 Volt, vorzugsweise aber im Bereich von -100 Volt bis -200 Volt. Der auf die Werkstücke gezogene Ionenstrom erreicht hierbei Werte von 5 bis 20 Ampere, wobei bevorzugterweise in einem Bereich von 8 bis 16 Ampere gearbeitet wird. Die Bearbeitungsbreite für das Werkstück oder die Werkstücke kann hierbei bis 1000 mm sein. Mit etwas mehr anlagenseitigem Aufwand sind aber auch grössere Bearbeitungsbreiten möglich. Die erreichbaren Werte hängen neben den Betriebswerten für die Bogenentladung auch von ihrer geometrischen Anordnung gegenüber dem Werkstück ab, wie auch vom gewählten Arbeitsdruck. Typische Arbeitsdrücke liegen im Bereich von 10⁻³ mb, wobei für den Betrieb der Bogenentladung ein Edelgas als Arbeitsgas verwendet wird, vorzugsweise ein schweres Edelgas, wie beispielsweise Argon.

Bis anhin wurden Niedervoltbogenentladungsanordnungen rotationssymetrisch betrieben, das heisst, die Bogenentladung wurde im Zentrum angeordnet, wobei die Werkstücke um diese Bogenentladung, welche in der zentralen Achse lag, rotierten. Man ging hierbei davon aus, dass die rotationssymetrische Anordnung mit der zentral angeordneten Bogenentladung die best möglichen Ergebnisse in Bezug auf Gleichförmigkeit und Geschwindigkeit des Ätzvorganges erzielen können. Es hat sich nun aber überraschenderweise gezeigt, dass die erfindungsgemässe asymetrische Anordnung insgesamt wesentlich vorteilhafter ist, als die vorerwähnte rotationssymetrische Anordnung. Bei der rotationssymetrischen Anordnung mit der Bogenentladung in der Zentralachse ist nämlich die Unterbringung von grossvolumigen Werkstücken gegen das Zentrum hin durch die Bogenentladung selber eingeschränkt. Ausserdem müssen solche Werkstücke neben der Rotation um die Zentralachse auch noch um sich selbst rotiert werden, damit die geätzten Werkstückflächen nach dem Ätzvorgang gleich auch beschichtet werden können mit den Beschichtungsquellen, die an der Kammerwand angeordnet sind. Nur auf diese Weise wird eine hinreichend gute homogene Verteilung des Ätzvorganges und der Beschichtung ermöglicht. Es hat sich auch gezeigt, dass der Abstand des Werkstückes von der Bogenentladung bei der rotationssymetrischen Anordnung kritischer ist, als bei der asymetrischen Anordnung, wo die Bogenentladung nur von einer Seite gegenüber dem Werkstück exponiert wird. Bei der erfindungsgemässen Anordnung ist es möglich, grossvolumige Werkstücke ohne zusätzliche Rotation vor der Bogenentladung vorbei zu führen, womit einerseits die Grösse der Bearbeitungskammer in einem vernünftigen Rahmen gehalten werden kann und andererseits die Handhabung der schweren Werkstücke wesentlich vereinfacht werden kann. Dies hat bei Produktionsanlagen eine grosse Auswirkung auf die Wirtschaftlichkeit. Die erfindungsgemässe Anordnung hat nicht nur Vorteile bei sehr grossen Werkstücken, es ist auch möglich an Stelle von grossvolumigen Werkstücken eine entsprechend grosse Vielzahl von kleinen Werkstücken unter zu bringen und gleichzeitig zu behandeln. Ein weiterer Vorteil der erfindungsgemässen Anordnung besteht darin, dass die Ätzeinrichtung nicht mehr als integraler Teil der Bearbeitungskammer ausgeführt werden muss, weil diese nur noch im Bereich der Bearbeitungskammerwand angeordnet werden muss und beispielsweise über eine langgezogene kleinere Entladungskammer an dieser Aussenwand angebracht werden kann, womit für die Ausgestaltung der Bearbeitungskammer ein wesentlich grösserer Freiheitsgrad besteht. Es wurde sogar festgestellt, dass diese Anordnung wesentlich weniger kritisch ist in Bezug auf die Beabstandung zwischen Bogenentladung und Werkstückoberfläche, womit reproduzierbarere Ergebnisse bei grösseren Abstandschwankungen, wie sie vor allem bei grossen Werkstücken entstehen, erreicht wird. Der Ionenstrom, der insgesamt aus der Bogenentladung extrahiert werden kann, erreicht nach wie vor die vorteilhaft hohen Werte und lässt sich vollständig auf die Werkstücke konzentrieren, was die erwünscht hohen Ätzraten bewirkt. Die eigentliche Trennung der Niedervoltbogenentladung beziehungsweise der Plasmaquelle von der Bearbeitungskammer beziehungsweise von der Behandlungszone erlaubt auch einen grösseren Freiheitsgrad in der Ausgestaltung dieser Quelle, womit eine wesentlich flexiblere Anpassung der Quellenkonstruktion an die Bedürfnisse des Verfahrens möglich wird, als bei der integralen rotationssymetrischen Anordnung mit der Entladung in der Zentralachse der Anlage.

Um nach dem Ätzvorgang eine haftfeste Schicht aufbringen zu können, wird von der gleichen Seite her wirkend, im Bereich der Bearbeitungskammerwand eine weitere oder mehrere weitere Verdampfungsquellen vorgesehen. Geeignet sind insbesondere solche Quellen, welche so angeordnet werden können, dass sie wie die langgezogene Niedervoltbogenentladung über einen entsprechend langgezogenen Bereich die vorbeibewegten Werkstücke beschichten. Dafür geeignet sind Quellen, wie beispielsweise Zerstäubungsquellen oder Arcverdampferquellen. Es hat sich heraus gestellt, dass die sogenannten kathodischen Funkenverdampfer beziehungsweise Arcverdampfer besonders geeignet sind, da mit diesen und dem vorhergehenden Ätzschritt besonders haftfeste Schichten erzeugt werden können, auf sehr wirtschaftliche Art. Mit dieser Anordnung konnten Testwerkzeuge Standleistungen erreichen, die deutlich und reproduzierbar bessere Werte aufwiesen, als bekannte arcbedampfte Schichten mit vorgängigem Hochspannungsätzen. Es konnte beispielsweise die Standzeit bei Schneidwerkzeugen, wie bei Fräsern um mindestens einen Faktor 1,5 verbessert werden. In besonders günstigen Fällen sogar um ein mehrfaches gegenüber konventionellen Techniken. Ausserdem konnte eine sehr homogene Ätzverteilung erreicht werden, die wesentlich unabhängiger ist von der Teilegeometrie und ausserdem die Mischbarkeit von verschiedensten Substraten pro Charge zulässt. Bei der vorgeschlagenen Anordnung ist es ausserdem möglich, neben Edelgasen auch Prozesse mit chemisch aktiven Gasen einfach zu realisieren, weil die Niedervoltbogenentladung die aktiven Gase, wie beispielsweise N₂, H₂ sehr gut aktiviert. Unerwünschte parasitäre Entladungen, welche durch isolierende Oberflächen entstehen, werden mit der Niedervoltbogenentladung ohne weiteres beherrscht. Vorteilhafterweise wird die Niedervoltbogenentladung mit einer separaten Kathodenkammer beziehungsweise Ionisationskammer betrieben, welche eine heisse Kathode aufnimmt und nur über eine kleine Öffnung mit der Entladungskammer beziehungsweise der Bearbeitungskammer verbunden ist. Die Gase werden vorteilhafterweise über diese Kathodenkammer eingelassen, womit gegenüber der Prozesskammer und den beteiligten Beschichtungsquellen eine gewisse Gastrennung entsteht, womit beispielsweise das Problem von Targetvergiftungen an den Beschichtungsquellen reduziert beziehungsweise vermieden wird. Mit dieser Anordnung ist es aber auch möglich, Aktivierungen mit verschiedenen Prozessgasen am Werkstück vorzunehmen, während der eigentlichen Beschichtungsphase. Hierbei kann wahlweise durch die Wahl der entsprechenden negativen oder gar positiven Spannung am Werkstück die gewünschten Arbeitsbedingungen eingestellt werden.

Da die Werkstücke für einen Prozesschritt in der Regel mehrfach vor den Quellen vorbei geführt werden müssen, um die notwendige Ätztiefe oder Beschichtungsdicke sowie eine gleichförmige und reproduzierbare Behandlung zu erreichen, ist es vorteilhaft, die Anlage so auszuführen, dass die Werkstücke um eine zentrale Achse rotiert werden können und die Quellen gleichwirkend von aussen nach innen im Bereich der Kammerwand angeordnet sind. Ein sehr grosses Werkstück kann beispielsweise auf diese Art in der Zentralachse rotierend angeordnet und bearbeitet werden. Es können aber in diesem Raumbereich auch eine Vielzahl von kleineren Werkstücken, ja sogar unterschiedlicher Grösse auf einer Halterung angeordnet werden und um diese zentrale Achse rotierend an den Quellen vorbeigeführt werden, um homogene Resultate zu erreichen. Eine solche Anordnung ist besonders einfach und kompakt zu realisieren und erlaubt das Arbeiten bei hoher Wirtschaftlichkeit.

Die Plasmaquelle beziehungsweise die Niedervoltbogenentladung wird mit Vorteil direkt im Bereich der Bearbeitungskammerwand quer zur Transportrichtung angeordnet. Die Niedervoltbogenentladungsvorrichtung kann beispielsweise und vorzugsweise in einem kastenähnlichen Anbau, hier als Entladungskammer, angeordnet werden, welche entlang der Entladung über eine schlitzförmige Öffnung mit der Bearbeitungskammer so verbunden ist, dass der Niedervoltbogen direkt gegenüber dem oder den Werkstücken beziehungsweise der zu bearbeitenden Zone ausgesetzt ist. Die Niedervoltbogenentladung wird erzeugt durch eine elektrisch geheizte beziehungsweise thermionische Emissionskathode und davon beabstandet einer Anode, wobei gegenüber der Kathode an die Anode eine entsprechende Entladungsspannung angelegt wird und hiermit ein Bogenstrom gezogen wird. In diese Entladungskammer mündet zusätzlich eine Gaseinlassanordnung, um die Bogenentladung mit dem Arbeitsgas zu versorgen. Vorzugsweise wird diese Anordnung mit einem Edelgas wie beispielsweise Argon betrieben, wobei aber wie erwähnt auch reaktive Gase beigemischt werden können. Die Entladungsstrecke sollte gegenüber der Behandlungszonenbreite mindestens eine Ausdehnung von 80% aufweisen und gegenüber der Behandlungszone so plaziert werden, dass die gewünschte Bearbeitungsverteilung beziehungsweise Homogenität erreicht werden kann. Um das entsprechende Zerstäubungsätzen am Werkstück zu bewirken, wird dieses oder die Werkstückhalterung mit einer negativen Spannung gegenüber der Bogenentladungsanordnung betrieben. Je nach Prozess, wie beispielsweise bei reaktiven Prozessen während dem Beschichtungsvorgang kann die Anordnung aber auch ohne eine solche Spannung oder gar mit einer positiven Spannung, das heisst mit Elektronenbeschuss betrieben werden. Hierbei ist es auch möglich neben einer reinen DC-Spannung eine AC-Wechselspannung zu verwenden, beispielsweise mit Mittel- oder Hochfrequenz, wobei auch Überlagerungen von DC mit AC möglich sind. Die DC-Spannung kann auch pulsierend betrieben werden, wobei auch nur ein Teil davon pulsierend überlagert werden kann. Mit solchen Versorgungen können bestimmte reaktive Prozesse gesteuert werden. Es kann aber vor allem auch bei Vorhandensein oder bei Ausbildung von dielektrischen Zonen an den Anlagen und Werkstückoberflächen vermieden werden, dass unerwünschte parasitäre Lichtbogen auftreten.

Die Verteilungsanforderungen an der Behandlungszone können einerseits durch die Länge der Entladung und andererseits durch ihre Position eingestellt werden. Ein weiterer Parameter für die Verteilungseinstellung ist die Plasmadichteverteilung entlang der Bogenentladung. Diese kann beispielsweise beeinflusst werden mit Hilfe von zusätzlichen Magnetfeldern, welche im Bereich der Entladungskammer angeordnet sind. Zur Einstellung und Korrektur werden in solch einem Fall Permanentmagnete entlang der Entladungskammer bevorzugt. Bessere Ergebnisse werden aber erreicht, wenn die Entladungsstrecke mit zusätzlichen Anoden betrieben wird, welche entsprechend den Verteilungsanforderungen entlang der Entladungsstrecke angeordnet sind und entsprechend separat gespiesen werden. Mit solch einer Anordnung hat man sogar eine gewisse Einstellmöglichkeit der Verteilungskurven. Die Anordnung ohne Korrekturmagneten mit mehr als einer Anode entlang der Entladungsstrecke ist eine bevorzugte Ausführungsform. Es ist aber auch möglich neben dieser bevorzugten Ausführungsform kombiniert einige Magnete zusätzlich zur Korrektur zu verwenden. Zusätzliche Anoden können ohne weiteres zusammen mit einer einzelnen Kathode betrieben werden. Es ist aber vorteilhaft, dass auch für jede Anode eine gegenüberliegende Emissionskathode vorgesehen ist, um eine optimale Entkopplung dieser Stromkreise zu erreichen, womit eine noch bessere Einstellbarkeit gewährleistet wird.

Bevorzugterweise wird die thermionische Emissionskathode in einer eigenen kleinen Kathodenkammer angeordnet, welche über eine kleine Öffnung mit der Entladungskammer verbunden ist. Eine Edelgaseinlassanordnung mündet vorzugsweise in diese Kathodenkammer ein. Bei Bedarf können über diese Gaseinlassanordnung auch Reaktivgase eingelassen werden. Reaktivgase werden aber vorzugsweise nicht in die Kathodenkammer eingelassen, sondern beispielsweise in die Entladungskammer. Über die Öffnung der Kathodenkammer werden die Elektronen auf die beabstandete Anode oder die Anoden gezogen, wobei das mindestens teilweise ionisierte Gas ebenfalls aus dieser Öffnung austritt. Die Bearbeitungskammer wird vorzugsweise so ausgebildet, dass die Zentralachse, um welche die Werkstücke rotieren, vertikal angeordnet ist. Hierbei wird die Kathode beziehungsweise die Kathodenkammer vorzugsweise oberhalb der Anode angeordnet. Bei der Kathodenkammer ist die Austrittsöffnung vorzugsweise nach unten gerichtet angeordnet. Diese Anordnungen vereinfachen die gesamte Handhabung des Systems und helfen Probleme zu vermeiden, die entstehen können durch Partikelbildung.

Neben der Niedervoltbogenentladungsanordnung weist die Bearbeitungskammer mindestens eine weitere Quelle auf, die vorzugsweise ein Arcverdampfer ist. Diese Quellen wirken gleichsinnig radial von aussen in Richtung Zentralachse beziehungsweise Behandlungszone. Günstig ist es, wenn die Niedervoltbogenentladung gegenüber der Transportrichtung vor der Beschichtungsquelle angeordnet ist. Üblicherweise hat ein Arcverdampfer ebenfalls wie die Bogenentladungsanordnung eine lineare Ausdehnung quer zur Transportrichtung, um die ganze Behandlungszone mit der gewünschten Homogenität beschichten zu können. Bei der vorliegenden Beschichtungsanordnung werden vorzugsweise mehrere runde Arcverdampfer eingesetzt, welche so an der Kammerwand verteilt angeordnet sind, dass die gewünschte Homogenität erreicht wird. Dies hat den Vorteil, dass einerseits die hohe Betriebsleistung der Verdampfer aufgeteilt werden kann und andererseits die Verteilung besser beherrscht werden kann, ja sogar in einem bestimmten Bereich über die Stromversorgung eingestellt werden kann. Damit können ausserordentlich hohe Bearbeitungsraten erzeugt werden, was eine hohe Wirtschaftlichkeit zur Folge hat. Beispielsweise sieht hierbei ein Prozess für die Bearbeitung von Werkzeugen, insbesondere für Umformwerkzeuge wie folgt aus:

### Prozessbeispiel

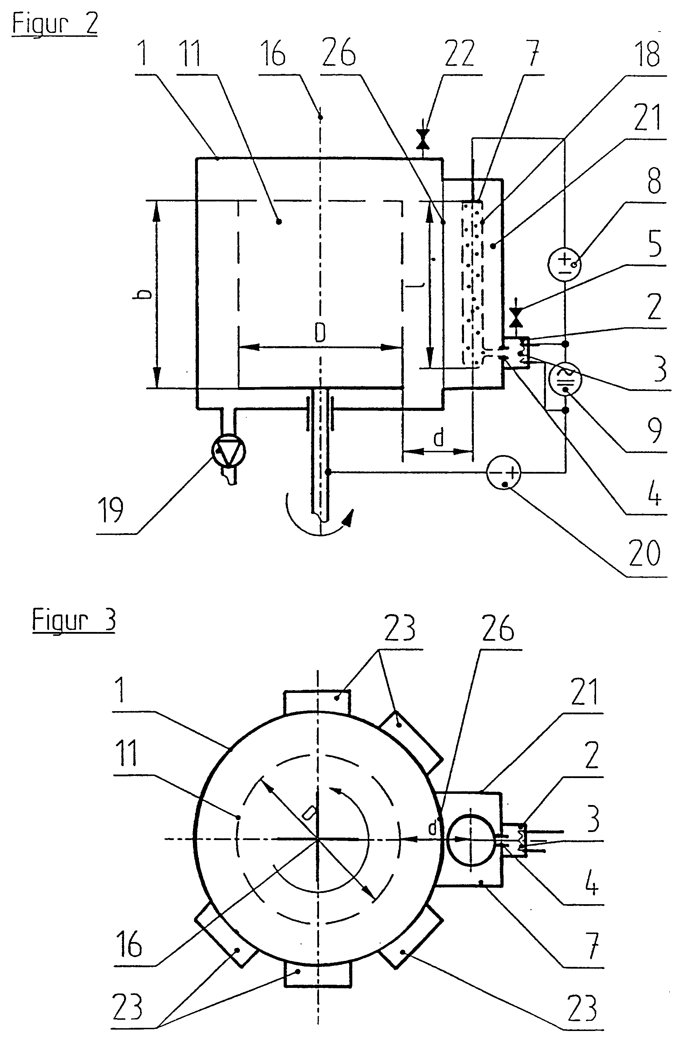

Die Anlagenkonfiguration entspricht derjenigen von Figur 2 und 3. Die Werkzeuge werden nicht um die eigene Achse rotiert, sondern nur an den Quellen vorbei geführt, indem die Werkstückhalterung um ihre Zentralachse rotiert wird. Es wird hierbei eine Behandlungszone gebildet mit einer Breite b von 1000 mm und einem Durchmesser D von 700 mm innerhalb der die Werkstücke angeordnet sind. Die Anlagenkammer weist hierbei einen Durchmesser von 1200 mm und eine Höhe von 1300 mm auf.

| **Ätzparameter:** | |
|---|---|
| Niedervolt-Bogenstrom | I_{LVA} = 200 A |
| Bogen-Entladungsspannung | U_{LVA} = 50 V |
| Argon-Druck | P_{Ar} = 2.0 x 10⁻³ mbar |
| Ätz-Spannung | U_{sub} = - 200 V |
| Ätzstrom | I_{sub} = 12 A |
| Ätzdauer | t = 30 min |
| Ätzabtrag | 200 nm |

| **Beschichtung:** | |
|---|---|
| Strom pro Arc-Verdampfer (8 Verdampfer mit Titan Targets ⌀ 150 mm) | I_{ARC} = 200 A |
| Arc-Entladungsspannung | U_{ARC} = 20 V |
| Stickstoff-Druck | P_{N2} = 1.0 x 10⁻² mbar |
| Bias-Spannung | U_{Bias} = -100 V |
| Beschichtungsdauer | t = 45 min |
| Schichtdicke TiN | 6 µm |

Die Prozess-Zykluszeit beträgt inklusiv Aufheizen und Abkühlen total 150 min für die Bearbeitung einer Charge.

Die Spannungserzeugungseinrichtung für die negative Beschleunigungsspannung am Werkstück wird in der Regel mit Spannungen bis 300 Volt DC betrieben, bevorzugterweise werden aber, um die Werkstücke zu schonen, die Spannungen tiefer betrieben im Bereich von 100 bis 200 Volt, wo noch gute Ätzraten ohne Defekte möglich sind. Die Niedervoltbogenanordnung muss vom Werkstück mindestens mit 10 cm beabstandet betrieben werden. Vorzugsweise liegt der Abstand aber > 15 cm, wobei dieser vorzugsweise im Bereich von 15 bis 25 cm liegen sollte. Hierbei werden hohe Raten bei guter Verteilung ermöglicht.

Die erfindungsgemässe Beschichtungsanlage ist besonders geeignet, um Werkzeuge wie insbesondere Bohrer, Fräser und Formungswerkzeuge zu bearbeiten. Die Halterungs- und Transporteinrichtung wird dann für die Aufnahme dieser Werkzeuge entsprechend ausgebildet. Die vorliegende Beschichtungsanordnung erlaubt es in der Regel gute Ergebnisse zu erzielen, auch wenn die zu beschichtenden Teile nur um die Anlagenzentralachse bewegt werden. In besonders kritischen Fällen oder wo eine sehr grosse Anzahl kleiner Teile von der Anlage aufgenommen werden, lässt es aber das Konzept ohne weiteres zu, neben der Rotation um die Zentralachse weitere rotierende Achsen einzuführen, welche ihrerseits um diese Zentralachse rotieren.

Die Erfindung wird anschliessend beispielsweise und schematisch anhand von Figuren erläutert.

Es zeigen:
- Fig. 1: Eine Beschichtungsanordnung mit Niedervoltbogenentladung gemäss Stand der Technik.
- Fig. 2: Ein Beispiel einer erfindungsgemässen Beschichtungsanordnung mit peripher angebrachter Entladungskammer für die Niedervoltbogenentladung im Querschnitt.
- Fig. 3: Eine Darstellung der Anlage gemäss Figur 2 im Horizontalschnitt.
- Fig. 4a: Ebenfalls im Querschnitt eine Darstellung eines Teils der Anordnung mit der Entladungskammer für die Niedervoltbogenentladung mit darin angebrachter Mehrfachanodenanordnung.
- Fig. 4b: Eine weitere Darstellung gemäss Figur 4a, wobei aber getrennte Kathoden-, Anodenentladungsstrecken mit eigenen zugeordneten Kathodenkammern gezeigt sind.
- Fig. 4c: Eine Darstellung gemäss den Figuren 4a und 4b, ebenfalls mit separaten Kathoden-, Anodenentladungsstrecken, wobei die Kathoden in einer gemeinsamen Kathodenkammer untergebracht sind.
- Fig. 5: Standzeitvergleichskurven für Werkzeug beschichtet nach Stand der Technik und gemäss Erfindung.

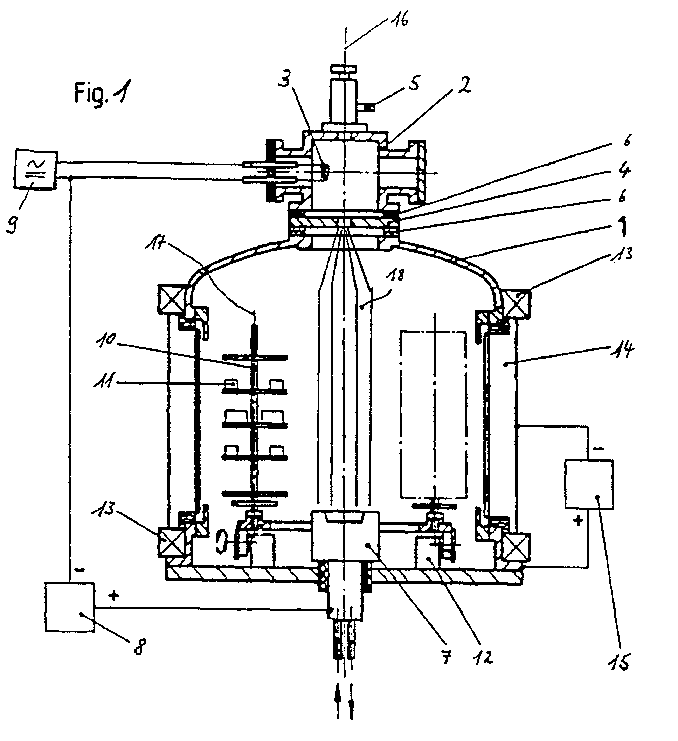

In Figur 1 ist eine bekannte Beschichtungsanordnung für Werkstücke dargestellt. Ein Vakuumrezipient bildet die Bearbeitungskammer 1 zur Aufnahme einer Niedervoltbogenentladung 18, welche sich im Zentrum des Rezipienten 1 entlang dessen Zentralachse 16 erstreckt und an der Peripherie von aussen an der Kammerwand der Bearbeitungskammer 1 Magnetronzerstäubungsquellen 14 angeflanscht sind. An der oberen Seite der Bearbeitungskammer 1 ist eine Kathodenkammer 2 angeordnet, welche eine thermionische heisse Glühkathode 3 aufnimmt und über einen Gaseinlass 5 mit dem Arbeitsgas, typischerweise ein Edelgas wie Argon, versorgt werden kann. Für reaktive Prozesse können aber auch aktive Gase beigemischt werden. Die Kathodenkammer 2 steht über eine Blende 4, welche eine kleine Öffnung aufweist mit der Bearbeitungskammer 1 in Verbindung. Die Kathodenkammer ist üblicherweise von der Bearbeitungskammer 1 über Isolatoren 6 getrennt. Die Blende 4 ist von der Kathodenkammer zusätzlich über einen Isolator 6 getrennt, so dass die Blende 4 nach Bedarf auf Schwebepotential oder auf einem Hilfspotential betrieben werden kann. In Zentralachsrichtung 16 auf der gegenüberliegenden Seite der Kathodenkammer 2 ist die Anode 7 angeordnet. Die Anode 7 kann als Tiegel ausgebildet werden zur Aufnahme eines Verdampfungsgutes, welches durch die Niedervoltbogenentladung verdampft werden kann. Beim Ätzvorgang wird aber diese Verdampfungsoption nicht benutzt, es werden dann lediglich aus der Niedervoltbogenentladung Ionen extrahiert und auf die Werkstücke beschleunigt, so dass diese Zerstäubungsgeätzt werden. Für den Betrieb der Niedervoltbogenentladung 18 wird die Kathode 3 mit einem Heizstromversorgungsgerät geheizt, so dass die Kathode 3 Elektronen emittiert. Zwischen der Kathode 3 und der Anode 7 ist eine weitere Stromversorgung 8 für den Betrieb der Bogenentladung vorgesehen. Diese erzeugt üblicherweise an der Anode 7 eine positive Gleichspannung, um den Niedervoltbogen 18 zu unterhalten. Zwischen der Bogenentladung 18 und der Kammerwand der Bearbeitungskammer 1 sind Werkstückhalterungen 10 angebracht, welche die Werkstücke 11 tragen, wobei diese, um genügend Gleichförmigkeit des Prozesses erreichen zu können, um ihre vertikale zentrale Achse 17 rotierbar sind. Des weiteren sind diese Werkstückhalterungen 10 auf einer weiteren Werkstückhalterungsanordnung 12 gelagert, welche mit einem Drehantrieb so versehen ist, dass diese Halterung die Werkstückhalterungen 10 um die zentrale Anlageachse 16 rotiert. Bei diesem Anlagentyp ist es zusätzlich notwendig, die Niedervoltbogenentladung 18 über zusätzliche Spulen 13, beispielsweise vom Typ Helmholzspulen zu bündeln. Es ist nun ersichtlich, dass die Werkstücke 11 mit der Niedervoltbogenentladung 18 bearbeitet werden können, dass durch Anlegen einer negativen Spannung an das Substrat ein Ionenbeschuss stattfindet und durch das Anlegen einer positiven Substratspannung ein Elektronenbeschuss des Werkstückes möglich ist. Die Werkstücke können auf diese Weise mit Hilfe einer Niedervoltbogenentladung vorbehandelt werden, einerseits bei Elektronenbeschuss durch Aufheizen und andererseits durch Ionenbeschuss mit Zerstäubungsätzen. Anschliessend kann dann das Werkstück 11 beschichtet werden, entweder durch Verdampfen mit dem Niedervoltbogen aus dem Tiegel 7 oder durch Bestäuben mit der Magnetronzerstäubungsquelle 14, welche mit der Stromversorgung 15 gespiesen wird. Bei der vorliegenden Anordnung ist es sofort ersichtlich, dass der mechanische Aufwand für die Substratbewegung und die Anordnung der Niedervoltbogenentladung gross ist. Andererseits ist der Freiheitsgrad stark eingeschränkt, da die Werkstücke nur zwischen der Niedervoltbogenentladung im Zentrum und der äusseren Kammerwand angeordnet werden können. Eine Anlage dieser Art ist vor allem für grosse Werkstücke oder grosse Chargenmengen wirtschaftlich nicht betreibbar.

Ein Beispiel einer erfindungsgemässen bevorzugten Beschichtungsanordnung ist in Figur 2 im Querschnitt dargestellt. Die Bearbeitungskammer 1 nimmt eine Halterung für Werkstücke 11 auf, welche so angeordnet ist, dass diese um die vertikale Zentralachse 16 der Bearbeitungskammer rotiert werden können. Die Kammer wird in üblicher Weise über Vakuumpumpen 19 evakuiert, welche die für die Bearbeitungsprozesse notwendigen Arbeitsdrücke aufrechterhalten. Bei der vorgeschlagenen Anordnung kann beispielsweise ein grosses Werkstück 11, welches über die Zentralachse 16 hinausreicht, in der Bearbeitungskammer 1 so angeordnet werden, dass dieses grosse Werkstück 11 durch die an der Bearbeitungskammerwand angeordneten Quellen bearbeitet werden kann. Die für die Chargierung nutzbare Zone füllt die Bearbeitungskammer 1 im wesentlichen vollständig aus. Somit ist nicht nur ein einzelnes grosses Werkstück 11 in solch einer Anordnung plazierbar, sondern auch eine grosse Anzahl Werkstücke, welche im wesentlichen das Kammervolumen ausfüllen und nutzen können.

Die Werkstückhalterung, welche die Werkstücke 11 um die Zentralachse 16 rotiert, spannt so quer zur Rotationsrichtung die Behandlungszone b auf, mit der vertikalen Ausdehnung b. Es ist besonders vorteilhaft, dass bei der erfindungsgemässen Anordnung einerseits über grosse Ausdehnungen der Behandlungszone b und andererseits über einen grossen Tiefenbereich von der Zentralachse 16 aus bis zur Peripherie der vertikalen Ausdehnung der Behandlungszone das heisst im gesamten Durchmesser D gleichförmige und reproduzierbare Behandlungsresultate erzielt werden können. Aufgrund der bisher bekannten konzentrischen Anordnung gemäss Stand der Technik, wo diese Verhältnisse kritisch sind, war nicht zu erwarten, dass eine exzentrische Anordnung gemäss vorliegender Erfindung bessere Resultate bringt. Verschiedenste Geometrien von Werkzeugformen mit feingliedrigen Kanten und Schneiden können über diesen grossen Bereich ohne Probleme bezüglich unerwünschter thermischer Belastung und unerwünschtem Auftreten von Lichtbögen beherrscht werden.

An der Bearbeitungskammeraussenwand sind die Quellen gleichwirkend von aussen gegen die Werkstücke gerichtet, die Bearbeitungsquellen für Ätzen und Beschichten angeordnet. Für den wichtigen Vorbehandlungsschritt des Zerstäubungsätzens ist an der Kammerwand eine schlitzförmige Öffnung vorgesehen, welche in ihrer Längsausdehnung mindestens der Ausdehnung b der Behandlungszone entspricht. Hinter dieser Öffnung 26 befindet sich eine kastenartig ausgebildete Entladungskammer 21, in welcher die Niedervoltbogenentladung 18 erzeugt wird. Diese Niedervoltbogenentladung 18 ist im wesentlichen parallel zur Ausdehnung b der Behandlungszone geführt und weist die Wirklänge 1 auf, welche mindestens 80% der Ausdehnung b aufweisen soll. Vorzugsweise sollte die Entladungslänge 1 aber der Ausdehnung b entsprechen oder diese sogar überlappen.

Die Achse der Bogenentladung 18 ist gegenüber der nächst liegenden Behandlungszone, das heisst dem nächstliegenden Werkstückteil mit dem Abstand d beabstandet, wobei der Abstand d mindestens 10 cm betragen soll, vorzugsweise aber im Bereich von 15 bist 25 cm liegen soll. Damit wird einerseits eine gute Gleichförmigkeit der Behandlung bewirkt und andererseits eine hohe Zerstäubungsrate eingehalten. Im unteren Teil der Entladungskammer 21 ist eine Kathodenkammer 2 angeflanscht, welche über eine Blende 4 mit der Entladungskammer 21 in Verbindung steht. Die Kathodenkammer 2 beinhaltet eine Glühkathode 3, welche über die Heizstromversorgung 9 gespiesen wird. Diese Speisung kann Wechselstrom oder Gleichstrom betrieben sein. In die Kathodenkammer 2 mündet eine Gaseinlassanordnung 5 für die Zuführung des Arbeitsgases, in der Regel ein Edelgas wie Argon oder eine Edelgas-Aktivgasmischung für bestimmte reaktive Prozesse. Zusätzlich können Arbeitsgase auch über die Bearbeitungskammer 1 mit Hilfe des Gaseinlasses 22 eingelassen werden. Aktivgase werden bevorzugt direkt in die Bearbeitungskammer 1 über den Gaseinlass 22 eingelassen.

An der oberen Seite der Entladungskammer 21 ist eine Elektrode 7 ausgebildet als Anode vorgesehen. Die Gleichstromversorgung 8 ist zwischen Kathode 3 und Anode 7 so geschaltet, dass der positive Pol an der Anode 7 liegt und somit eine Niedervoltbogenentladung gezogen werden kann. Durch Anlegen einer negativen Spannung an die Werkstückhalterung beziehungsweise an die Werkstücke 11 mit Hilfe der Spannungserzeugung 20 zwischen der Niedervoltbogenentladungsanordnung und dem Werkstück 11, werden Argonionen auf die Werkstücke beschleunigt, so dass die Oberfläche Zerstäubungsgeätzt wird. Dies kann mit Beschleunigungsspannungen von bis zu 300 Volt DC erfolgen, wobei aber vorzugsweise ein Wert gewählt wird im Bereich von 100 Volt bis 200 Volt, um eine schonende Bearbeitung der Werkstücke 11 zu gewährleisten. Die Gleichförmigkeit der Behandlung kann durch entsprechendes Plazieren einerseits der Kathodenkammer 2 und andererseits der Anode 7 gegenüber der Behandlungszone b der zu behandelnden Werkstücke 11 entsprechend den gewünschten Anforderungen eingestellt werden. Ein weiterer Faktor ist die Formgebung der Anode 7. Diese kann beispielsweise als flächenförmige Elektrode wie tellerförmig, rechteckförmig ausgebildet sein oder beispielsweise als rohrförmige gekühlte Anode.

In Figur 3 ist ein horizontaler Querschnitt der Anlage nach Figur 2 dargestellt. Ersichtlich ist wiederum die kastenförmig ausgestülpte Entladungskammer 21 an der Aussenwand der Bearbeitungskammer 1, welche mit der Schlitzöffnung 26 mit der Behandlungszone in Verbindung steht. Selbstverständlich können je nach Bedarf mehrere solche Entladungskammern an einer Anlage angeordnet werden, beispielsweise um die Wirkung der Behandlung weiter zu erhöhen. Weiterhin dargestellt sind Verdampfungsquellen 23, welche an der Kammerwand angeflanscht sind. Als Verdampfungsquellen 23 können beispielsweise Magnetronzerstäubungsquellen dienen, vorzugsweise werden aber, um hohe Behandlungs geschwindigkeiten bei tiefen Kosten zu erhalten, sogenannte Arcverdampfungsquellen verwendet. Die vorliegende Anordnung hat den Vorteil, dass die Arcverdampfungsquellen 23 von aussen frei so plaziert werden können, dass durch die verteilte Anordnung von mehreren Quellen einerseits die gewünschte Beschichtungshomogenität eingestellt werden kann und andererseits durch Verwendung von mehreren Quellen die Beschichtungsrate hochgehalten werden kann. Hierbei hat es sich gezeigt, dass es vorteilhafter ist nicht einzelne rechteckige Verdampfungsquellen einzusetzen, sondern mehrere kleinere runde Quellen, die entsprechend den Anforderungen auf der Anlagenperipherie verteilt angeordnet sind.

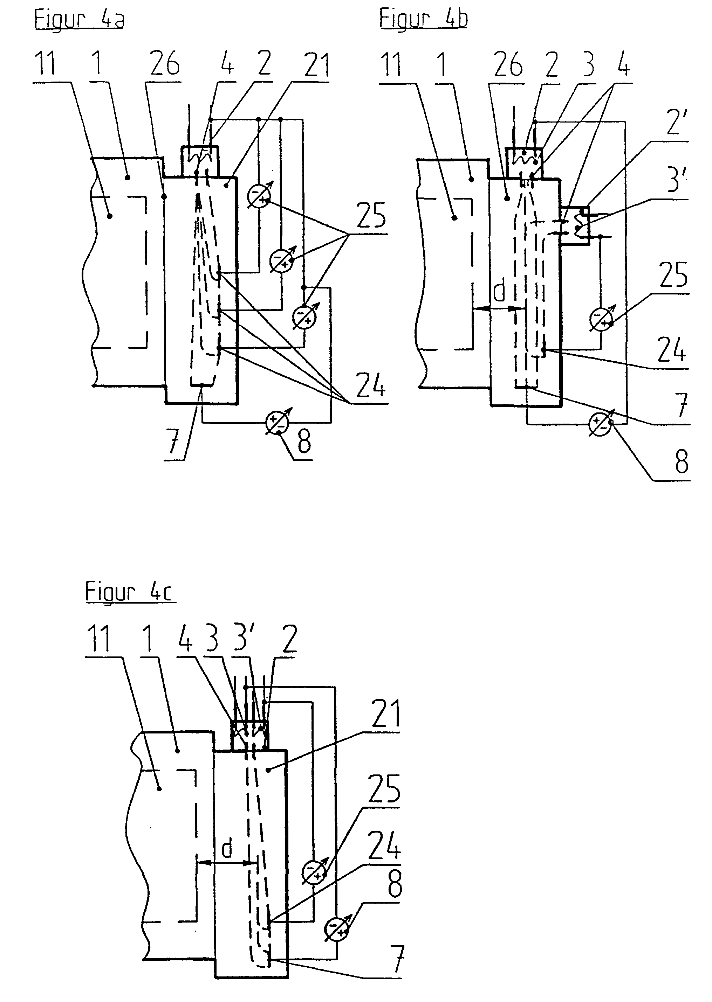

In Figur 4a wird eine weitere vorteilhafte Ausbildung der erfindungsgemässen Anordnung gezeigt, in welcher die Kathodenkammer 2 an der Oberseite der Entladungskammmer 21 angeordnet ist. Dies hat den Vorteil, dass Partikel, welche in einer solchen Beschichtungsanlage immer vorkommen, den Betrieb der Entladungsstrecke am wenigsten stören. Des weiteren ist eine Möglichkeit dargestellt, durch Verwenden von mehreren Anoden-, Kathodenstromkreisen, die Entladungsstrecke aufzuteilen und die Intensität entlang der Entladung 1 einstellbar zu machen. Die Hauptentladung wird mit der Stromversorgung 8 zwischen der Hauptanode 7 und der Kathodenkammer 2 erzeugt. Weitere Nebenentladungen können mit Hilfsanoden 24 und Hilfsstromversorgungen 25 erzeugt werden. Hiermit ist es möglich die Leistungsdichte der Entladung über die gesamte Entladungsstrecke zwischen Anode 7 und Kathodenkammer 2 örtlich und intensitätsmässig den Homogenitätsanforderungen am Werkstück anzupassen.

In Figur 4b ist eine weitere Möglichkeit der Anpassung dargestellt. Die Anoden-, Kathodenstrecken können voneinander vollständig getrennt, ja sogar entkoppelt werden, dadurch dass nicht nur separate Anoden 7, 24 verwendet werden, sondern auch separate Kathoden 3, 3' und separate Kathodenkammern 2, 2'. Eine weitere Variante ist in Figur 4c gezeigt, wo zwei separate Anoden 7, 24 verwendet werden, aber ein gemeinsame Kathodenkammer 2 mit zwei Glühkathoden 3 und 3'.

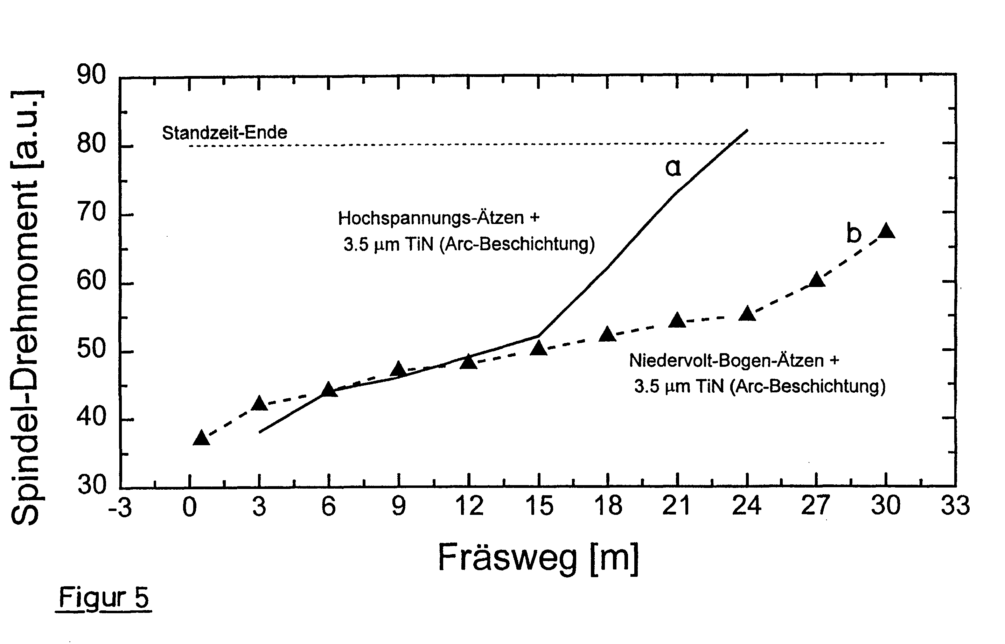

In Figur 5 ist das Testergebnis von HSS-Schlichtfräsern dargestellt welche einerseits erfindungsgemäss (Kurve b) und anderseits gemäss Stand der Technik (Kurve a) behandelt wurden. In beiden Fällen wurden die Fräser mit einer 3,5 µm dicken TiN Beschichtung versehen. Beim Fräser gemäss Stand der Technik (Kurve a) wurde in bekannter Art vorgängig ein Hochspannungsätzen durchgeführt, wobei bei dem Fräser nach Kurve b das erfinderische Verfahren angewendet wurde. Die Testbedingungen waren wie folgt:

| | |
|---|---|
| HSS-Schlichtfräser | ⌀ 16 mm |
| Anzahl Zähne | 4 |
| | |
| Testmaterial | 42 CrMo4 (DIN 1.7225) |
| Härte | HRC 38.5 |
| | |
| Zustellung | 15 mm X 2.5 mm |
| Schnittmeter | 40 m/min |
| Vorschub pro Zahn | 0.088 mm |
| Vorschub | 280 mm/min |

### Standzeit-Ende: Spindel-Drehmoment 80 (willkürliche Einheit)

Das Ergebnis zeigt eindeutige Verbesserungen in der Standzeit des erfindungsgemäss behandelten Werkzeuges. Eine Verbesserung um einen Faktor 1,5 und mehr wird ohne weiteres erreicht. Wichtig ist aber nicht nur die Standzeitverlängerung alleine sondern auch der flachere Verlauf des ansteigenden Drehmomentes bzw. den Grad der Werkzeugqualitätsverschlechterung gegen Ende der Lebensdauerkurve. Im Beispiel gemäss Fig. 5 ist dies deutlich ab 15 m Fräsweg erkennbar. Die Kurve a gemäss Stand der Technik knickt bei 15 m Fräsweg steil ab. Dies bedeutet, dass die Schneidqualität gemäss Stand der Technik über die gesamte Standzeit grössere Änderungen aufweist, das heisst nicht sehr konstant ist.

Erfindungsgemässe Anlagen gemäss den Figuren 2 bis 4 erreichen ausserdem, beispielsweise gegenüber dem Stand der Technik nach Fig. 1, wesentlich höhere Durchsätze bei der vorerwähnten hohen Qualität. Durchsätze können hierbei ohne weiteres verdoppelt werden oder gar um den Faktor 3 bis 5 erhöht werden, was die Wirtschaftlichkeit drastisch steigert.

## Patentansprüche

1. Beschichtungsanordnung zum Behandeln von Werkstücken (11) mit einer evakuierbaren Bearbeitungskammer (1) und einer an der Kammer (1) angeordneten Heisskathoden-Niedervoltbogen-Plasmaquelle (18) und einer Beschichtungsquelle (23) und mit einer in der Kammer angeordneter Halte- und Transportvorrichtung, welche eine Behandlungszone (b) festlegt für die Positionierung oder Vorbeiführung der Werkstücke (11) vor den Quellen (18, 23), wobei die Quellen von der gleichen Seite her wirkend und beabstandet zum Werkstück (11) angeordnet sind und dass die Plasmaquelle eine vertikale Ausdehnung (l) quer zur Bewegungsrichtung der Werkstücke aufweist, die im wesentlichen der vertikalen Ausdehnung (b) der Behandlungszone entspricht und dass eine Einrichtung (20) vorgesehen ist zur Erzeugung einer elektrischen Spannung zwischen der Bogenentladung (18) der Plasmaquelle und dem Werkstück (11) **dadurch gekennzeichnet, dass** die Halte- und Transportvorrichtung für die Werkstücke (11) um die Zentralachse (16) der Kammer (1) rotierbar angeordnet ist und dass die Quellen (18, 23) an der Kammerwand gleichwirkend radial, von aussen in Richtung der Zentralachse (16) wirkend, angeordnet sind.

2. Anordnung nach Anspruch 1 **dadurch gekennzeichnet, dass** die Plasmaquelle (18) in einer Entladungskammer (21) angeordnet ist, welche an der Aussenwand der Kammer (1) angebracht ist, wobei in oder an der Entladungskammer (21) eine thermionische Emissionskathode (3) und davon um mindestens 80% der vertikalen Ausdehnung (b) der Behandlungszone beabstandet und entlang der vertikalen Ausdehnung der Behandlungszone eine Anode (7) zur Ausbildung einer Niedervoltbogenanordnung (18) enthalten ist und dass eine Edelgaseinlassanordnung (5) in die Entladungskammer (21) mündet, wobei eine Spannungserzeugungseinrichtung (20) zwischen dem Anoden-Kathodenstromkreis und dem Werkstück (11) so verbunden ist, dass der negative Pol am Werkstück (11) liegt, so dass die Plasmaquellenanordnung (2,7,18,21) als Vorrichtung zum Zerstäubungsätzen ausgebildet ist.

3. Anordnung nach einem der vorhergehenden Ansprüche **dadurch gekennzeichnet, dass** zwischen der Emissionskathode (3) und der Anode (7) mindestens eine weitere, entlang der Plasmastrecke beabstandete Anode (24), angeordnet ist, zur Einstellung der Plasmadichteverteilung entlang der Bogenentladung (18).

4. Anordnung nach einem der vorhergehenden Ansprüche **dadurch gekennzeichnet, dass** die Anode (7) und die weitere Anode (24) mit separaten, einstellbaren Stromversorgungen (25) verbunden sind und dass vorzugsweise für jede Anode (7,25) eine gegenüberliegende Kathode (3) eingebaut ist, welche mit der zugeordneten Anode (7,25) und der separaten Stromversorgung (8,25) einen eigenen einstellbaren Stromkreis schliesst.

5. Anordnung nach einem der vorhergehenden Ansprüche **dadurch gekennzeichnet, dass** die Emissionskathode (3) in einer gegenüber der Entladungskammer (21) separaten Kathodenkammer (2) angeordnet ist und diese mit der Entladungskammer (21) über eine Öffnung (4) für den Elektronenaustritt verbunden ist, wobei die Edelgaseinlassanordnung (5) vorzugsweise in diese Kathodenkammer (2) mündet.

6. Anordnung nach einem der vorhergehenden Ansprüche 2 bis 6 **dadurch gekennzeichnet, dass** dass die Kathode (3) beziehungsweise die Kathodenkammer (2) oberhalb der Anode (7,24) angeordnet ist und die Öffnung (4) der Kathodenkammer (2) vorzugsweise nach unten gerichtet ist.

7. Anordnung nach einem der vorhergehenden Ansprüche **dadurch gekennzeichnet, dass** mindestens eine Beschichtungsquelle (23), die vorzugsweise mindestens ein Arc-Verdampfer (23) ist, neben der in Transportrichtung davor liegenden Plasmaquelle (18), an der Bearbeitungskammerwand angeordnet ist, wobei der mindestens eine Arc-Verdampfer (23) vorzugsweise als runde Quelle ausgebildet ist.

8. Anordnung nach einem der vorhergehenden Ansprüche **dadurch gekennzeichnet, dass** die Spannungserzeugungseinrichtung (20) für Werte bis 300 V DC ausgelegt ist, vorzugsweise für 100 V bis 200 V.

9. Anordnung nach einem der vorhergehenden Ansprüche **dadurch gekennzeichnet, dass** die Niedervoltbogenanordnung (18) von dem Werkstück (11) mindestens 10 cm beabstandet ist, vorzugsweise aber 15 bis 25 cm.

10. Anordnung nach einem der vorhergehenden Ansprüche **dadurch gekennzeichnet, dass** die Halte- und Transporteinrichtung als Werkzeughaltevorrichtung ausgebildet ist, insbesondere für Bohrer, Fräser und Formungswerkzeuge.

11. Anordnung nach einem der vorhergehenden Ansprüche **dadurch gekennzeichnet, dass** in oder an der Entladungskammer (21) mindestens eine Magnetfelderzeugungsvorrichtung angeordnet ist zur Einstellung der Plasmadichteverteilung.

12. Anordnung nach einem der vorhergehenden Ansprüche **dadurch gekennzeichnet, dass** die Entladungskammer (21) auf der ganzen vertikalen Ausdehnung (b) der Behandlungszone gegenüber dieser offen ist, so dass die Behandlungszone gegenüber der Bogenentladung exponiert ist.

13. Verfahren zur wenigstens teilweisen Beschichtung von Werkstücken (11) in einer evakuierbaren Bearbeitungskammer (1) mit einer an der Kammer angeordneten Plasmaquelle (18) und einer Beschichtungsquelle (23) und mit einer in der Kammer (1) angeordneten Halte- und Transportvorrichtung, welche eine Behandlungszone (b) bestimmt für die Positionierung oder Vorbeiführung der Werkstücke (11) vor den Quellen (18,23), wobei die Quellen von der gleichen Seite her wirkend und beabstandet zur Werkstück (11) angeordnet sind und dass die Plasmaquelle (18) eine vertikale Ausdehnung (l) quer zur Bewegungsrichtung der Werkstrücke (11) aufweist, die im wesentlichen der vertikalen Ausdehnung (b) der Behandlungszone entspricht und dass eine Spannung zwischen der Bogenentladung und dem Werkstück angelegt wird zur Extraktion von Ladungsträgern aus dem Plasma und zur Beschleunigung auf das Substrat **dadurch gekennzeichnet, dass** mit der Plasmaquelle (18) ein Heisskathoden-Niedervoltbogen (18) quer zur Werkstücktransportrichtung im wesentlichen über mindestens 80% der (b) vertikalen Ansdehnung der Behandlungszone erzeugt wird und dass die Halte- und Transportvorrichtung für die Werkstücke (11) um die Zentralachse (16) der Kammer (1) rotiert, wobei die Quellen (18, 23) an der Kammerwand, gleichwirkend radial, von aussen in Richtung der Zentralachse (16) betrieben werden können.

14. Verfahren nach Anspruch 13 **dadurch gekennzeichnet, dass** die Werkstücke um die Zentralachse (16) einer Bearbeitungskammer vor die Quelle (18,23) rotieren, vorzugsweise kontinuierlich rotieren und in einem ersten Schritt die Plasmabehandlung mit Ladungsträgerbeschuss erfolgt und in einem zweiten Schritt die Beschichtung der Werkstücke (11) erfolgt.

15. Verfahren nach Anspruch 13 oder 14 **dadurch gekennzeichnet, dass** die Ladungsträger Ionen sind, die aus der Bogenentladung (18) direkt mit Hilfe einer negativen Werkstückspannung so extrahiert werden, dass diese das Werkstück (11) zerstäubungsätzen.

16. Verfahren nach einem der Ansprüche 13 bis 15 **dadurch gekennzeichnet, dass** die Homogenität der Ätzverteilung über der vertikalen Ausdehnung (b) der Behandlungszone auf vorgegebene Werte eingestellt wird durch die Wahl der Bogenlänge (1), des Abstandes (d) zwischen dem Bogen und der Werkstücke, der Position des Bogens gegenüber dem Werkstück sowie durch Einstellung der Plasmadichteverteilung entlang des Lichtbogens.

## Claims

1. A coating arrangement for the treatment of workpieces (11) comprising an evacuatable processing chamber (1) and a hot-cathode low-voltage arc plasma source (18) arranged at the chamber (1) and a coating source (23) and a holding and transport device which is arranged in the chamber and which establishes a treatment zone (b) for positioning or moving the workpieces (11) in front of the sources (18, 23), wherein the sources are arranged to act from the same side and at a spacing in relation to the workpiece (11) and the plasma source is of a vertical extent (I) transversely with respect to the direction of movement of the workpieces which substantially corresponds to the vertical extent (6) of the treatment zone, and there is provided a device (20) for producing an electrical voltage between the arc discharge (18) of the plasma source and the workpiece (11) **characterised in that** the holding and transport device for the workpieces (11) is arranged rotatably about the central axis (16) of the chamber (1) and the sources (18, 23) are arranged at the chamber wall equally acting radially, operative from the exterior in the direction of the central axis (16).

2. An arrangement according to claim 1 **characterised in that** the plasma source (18) is arranged in a discharge chamber (21) mounted to the outside wall of the chamber (1), wherein contained in or on the discharge chamber (21) is a thermionic emission cathode (3) and spaced therefrom by at least 80% of the vertical extent (b) of the treatment zone and along the vertical extent of the treatment zone is an anode (7), for providing a low-voltage arc arrangement (18), and that an inert gas inlet arrangement (5) opens into the discharge chamber (21), wherein a voltage-producing device (20) is connected between the anode-cathode circuit and the workpiece (11) in such a way that the negative pole is at the workpiece (11) so that the plasma source arrangement (2, 7, 18, 21) is in the form of a sputtering etching device.

3. An arrangement according to one of the preceding claims **characterised in that** arranged between the emission cathode (3) and the anode (7) is at least one further anode (24) spaced along the plasma path, for adjusting the plasma density distribution along the arc discharge (18).

4. An arrangement according to one of the preceding claims **characterised in that** the anode (7) and the further anode (24) are connected to separate adjustable current supplies (25) and that preferably there is installed for each anode (7, 25) an oppositely disposed cathode (3) which with the associated anode (7, 25) and the separate current supply (8, 25) closes its own adjustable circuit.

5. An arrangement according to one of the preceding claims **characterised in that** the emission cathode (3) is arranged in a cathode chamber (21) which is separate in relation to the discharge chamber (21) and the cathode chamber is connected to the discharge chamber (21) by way of an opening (4) for electron exit, wherein the inert gas inlet arrangement (5) preferably opens into said cathode chamber (2).

6. An arrangement according to one of preceding claims 2 to 5 **characterised in that** the cathode (3) or the cathode chamber (2) respectively is arranged above the anode (7, 24) and the opening (4) of the cathode chamber (2) is preferably directed downwardly.

7. An arrangement according to one of the preceding claims **characterised in that** at least one coating source (23) which is preferably at least one arc vaporiser (23) is arranged beside the plasma source (18) disposed in front thereof in the transport direction, at the processing chamber wall, wherein the at least one arc vaporiser (23) is preferably in the form of a round source.

8. An arrangement according to one of the preceding claims **characterised in that** the voltage-producing device (20) is designed for values of up to 300 V DC, preferably for 100 V to 200 V.

9. An arrangement according to one of the preceding claims **characterised in that** the low-voltage arc arrangement (18) is spaced at least 10 cm, but preferably from 15 to 25 cm, from the workpiece (11).

10. An arrangement according to one of the preceding claims **characterised in that** the holding and transport device is in the form of a tool holding device, in particular for drills, milling cutters and shaping tools.

11. An arrangement according to one of the preceding claims **characterised in that** at least one magnetic field-producing device is arranged in or at the discharge chamber (21) to adjust the plasma density distribution.

12. An arrangement according to one of the preceding claims **characterised in that** the discharge chamber (21) is open in relation to the treatment zone over the entire vertical extent (b) thereof so that the treatment zone is exposed with respect to the arc discharge.

13. A process for at least partially coating workpieces (11) in an evacuatable processing chamber (1) with a plasma source (18) arranged at the chamber and a coating source (23) and a holding and transport device which is arranged in the chamber (1) and which determines a treatment zone (b) for positioning or moving the workpieces (11) in front of the sources (18, 23), wherein the sources are arranged to act from the same side and spaced in relation to the workpiece (11) and the plasma source (18) is of a vertical extent (I) transversely with respect to the direction of movement of the workpiece (11), which substantially corresponds to the vertical extent of the treatment zone, and a voltage is applied between the arc discharge and the workpiece for extraction of charge carriers from the plasma and for acceleration on to the substrate, **characterised in that** a hot-cathode low-voltage arc (18) is produced with the plasma source (18) transversely with respect to the workpiece transport direction substantially over at least 80% of the vertical extent (b) of the treatment zone and the holding and transport device for the workpieces (11) rotates about the central axis (16) of the chamber (1), wherein the sources (18, 23) can be operated on the chamber wall, equally acting radially, from the outside in the direction of the central axis (16).

14. A process according to claim 13 **characterised in that** the workpieces rotate, preferably continuously, about the central axis (16) of a processing chamber in front of the source (18, 23) and in a first step plasma treatment with charge carrier bombardment is effected and in a second step coating of the workpieces (11) is effected.

15. A process according to claim 13 or claim 14 **characterised in that** the charge carriers are ions which are extracted from the arc discharge (18) directly by means of a negative workpiece voltage in such a way that they sputter-etch the workpiece (11).

16. A process according to one of claims 13 to 15 **characterised in that** the homogeneity of the etching distribution over the vertical extent (b) of the treatment zone is adjusted to predetermined values by the choice of the arc length (1), the spacing (d) between the arc and the workpieces, the position of the arc with respect to the workpiece and by adjustment of the plasma density distribution along the arc.

## Revendications

1. Dispositif de revêtement pour le traitement de pièces (11) qui inclut une chambre de travail (1) susceptible d'être mise en dépression et une source (18) de plasma à arc à basse tension à cathode chaude agencée sur la chambre (1) et une source (23) de revêtement et inclut aussi un dispositif de maintien et de transport qui est agencé dans la chambre et définit une zone de traitement (b) pour le positionnement et le défilement des pièces (11) devant les sources (18, 23), dans lequel les sources sont agencées à distance de la pièce (11) de manière à intervenir à partir du même côté, et dans lequel la source de plasma présente une extension verticale orientée transversalement à la direction de déplacement des pièces et correspondant sensiblement à l'extension verticale (b) de la zone de traitement et dans lequel un agencement (20) est prévu pour engendrer une tension électrique entre la décharge (18) d'arc de la source de plasma et la pièce (11), **caractérisé en ce que** le dispositif de maintien et de transport des pièces (11) est agencé à rotation autour de l'axe central (16) de la chambre (1) et **en ce que** les sources (18, 23) sont agencées sur la paroi de chambre de façon à exercer le même effet orienté radiaiement de l'extérieur en direction de l'axe central (16).

2. Agencement selon la revendication 1, **caractérisé en ce que** la source (18) de plasma est agencée dans une chambre de décharge (21) qui est montée sur la paroi extérieure de la chambre (1), dans lequel une cathode d'émission thermoïonique (3) et une anode (7) qui en est espacée et s'étend sur l'extension verticale sur 80% au moins de l'extension verticale (b) sont contenues dans la chambre de décharge (21) ou agencées sur celle-ci pour constituer un agencement (18) d'arc à basse tension, et **en ce qu'**un agencement d'admission (5) de gaz nobles débouche dans la chambre de décharge (21), un agencement générateur (20) de tension étant connecté entre le circuit anode-cathode et la pièce (11) d'une manière telle que le pôle négatif est appliqué à la pièce (11) de sorte que l'agencement (2, 7, 18, 21) de source de plasma constitue un dispositif de gravure par pulvérisation.

3. Agencement selon l'une quelconque des revendications précédentes, **caractérisé en ce qu'**au moins une autre anode (24) est agencée entre la cathode d'émission (3) et l'anode (7) à distance le long du trajet de plasma pour régler la répartition de densité de plasma le long de la décharge d'arc (18).

4. Agencement selon l'une quelconque des revendications précédentes **caractérisé en ce que** l'anode (7) et l'anode (24) sont connectées à des alimentations réglables séparées (25) de courant et **en ce qu'**une cathode (3) qui ferme un circuit propre réglable avec l'anode associée (7, 25) et l'alimentation séparée (8, 25) en courant est de préférence montée pour chaque anode (7, 25).

5. Agencement selon l'une quelconque des revendications précédentes **caractérisé en ce que** la cathode d'émission (3) est agencée dans une chambre (2) de cathode qui est séparée de la chambre de décharge (21) et qui est reliée à la chambre de décharge (21) par une ouverture (4) pour la sortie d'électrons, l'agencement (5) d'admission de gaz nobles débouchant de préférence dans cette chambre (2) de cathode.

6. Agencement selon l'une quelconque des revendications 2 à 6 **caractérisé en ce que** la cathode (3) ou la chambre (2) de cathode est agencée au-dessus de l'anode (7, 24) et l'ouverture (4) de la chambre (2) de cathode est de préférence orientée vers le bas.

7. Agencement selon l'une quelconque des revendications précédentes **caractérisé en ce qu'**au moins une source de revêtement (23) qui est de préférence au moins un évaporateur à arc (23) est agencé sur la paroi de la chambre de travail à coté de la source (18) de plasma qui la précède dans la direction de transport, la configuration de l'évaporateur (23) à arc unique au moins étant de préférence en une source ronde.

8. Agencement selon l'une quelconque des revendications précédentes **caractérisé en ce que** le générateur (20) de tension est spécifié pour des valeurs pouvant atteindre 300 V en courant continu, de préférence pour des valeurs de 100 V à 200 V.

9. Agencement selon l'une quelconque des revendications précédentes, **caractérisé en ce que** l'agencement (18) d'arc à basse tension est éloigné d'au moins 10 cm, mais de préférence de 15 à 25 cm, de la pièce (11).

10. Agencement selon l'une quelconque des revendications précédentes **caractérisé en ce que** le dispositif de maintien et transport consiste en un dispositif de maintien d'outil, en particulier pour des aléseurs, des fraises, et des outils de formage.

11. Agencement selon l'une quelconque des revendications précédentes **caractérisé en ce qu'**au moins un dispositif générateur de champ magnétique est agencé dans ou sur la chambre de décharge (21) pour régler la répartition de densité de plasma.

12. Agencement selon l'une quelconque des revendications précédentes, **caractérisé en ce que** la chambre de décharge (21) est ouverte vers la zone de traitement sur toute l'extension verticale (b) de cette zone de sorte que la zone de traitement est exposée à la décharge d'arc.

13. Procédé de revêtement au moins partiel de pièces (11) dans une chambre de travail (1) susceptible d'être mise en dépression et une source (18) de plasma agencée sur la chambre (1) et une source (23) de revêtement et inclut aussi un dispositif de maintien et de transport qui est agencé dans la chambre (1) et définit une zone de traitement (b) pour le positionnement et le défilement des pièces (11) devant les sources (18, 23), dans lequel les sources sont agencées à distance de la pièce (11) de manière à intervenir à partir du même côté, et dans lequel la source (18) de plasma présente une extension verticale (I) orientée transversalement à la direction de déplacement des pièces (11) et correspondant sensiblement à l'extension verticale (b) de la zone de traitement, et dans lequel une tension est appliquée entre la décharge d'arc et la pièce pour extraire des porteurs de charge hors du plasma et les accélérer sur le substrat, **caractérisé en ce que** la source (18) de plasma engendre un arc (18) à basse tension à cathode chaude transversalement à la direction de transport de pièce, sensiblement sur au moins 80% de l'extension verticale (b) de la zone de traitement et **en ce que** le dispositif de maintien de transport des pièces (11) tourne autour de l'axe central (16) de la chambre (1), les sources (18, 23) agencées sur la paroi de chambre pouvant être excitées. de façon à exercer le même effet orienté radialement de l'extérieur en direction de l'axe central (16).

14. Procédé selon la revendication 13, **caractérisé en ce que** les pièces tournent autour de l'axe central (16) d'une chambre de travail devant la source (18, 23), tournent de préférence en continu et qu'il en résulte dans une première étape le traitement plasma avec bombardement de porteurs de charge et dans une deuxième étape le revêtement des pièces (11) est effectué.

15. Procédé selon la revendication 13 ou 14 **caractérisé en ce que** les porteurs de charge sont des ions qui sont extraits directement de la décharge d'arc (18) à l'aide d'une tension négative de pièces de sorte qu'ils gravent la pièce (11) par pulvérisation.

16. Procédé selon l'une quelconque des revendications 13 à 15, **caractérisé en ce que** l'homogénéité de la répartition de gravure sur l'extension verticale (b) de la zone de traitement est réglée à des valeurs prédéfinies par la sélection de la longueur (I) de l'arc, de la distance (d) entre l'arc et les pièces, de la position de l'arc par rapport à la pièce ainsi que par un réglage de la répartition de densité de plasma le long de l'arc électrique.
